(19) **Europäisches Patentamt / European Patent Office / Office européen des brevets**

(11) **EP 4 242 280 A1**

(12) **EUROPEAN PATENT APPLICATION**
published in accordance with Art. 153(4) EPC

(43) Date of publication:
**13.09.2023 Bulletin 2023/37**

(21) Application number: **21889025.9**

(22) Date of filing: **20.10.2021**

(51) International Patent Classification (IPC):
**C09J 133/04** (2006.01)     **C09J 175/04** (2006.01)
**C09J 201/02** (2006.01)     **H01L 21/301** (2006.01)
**C09J 7/38** (2018.01)

(52) Cooperative Patent Classification (CPC):
**C09J 7/38; C09J 133/04; C09J 175/04;
C09J 201/02; H01L 21/30**

(86) International application number:
**PCT/JP2021/038724**

(87) International publication number:
**WO 2022/097472 (12.05.2022 Gazette 2022/19)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **09.11.2020   JP 2020186366**

(71) Applicant: **Denka Company Limited
Tokyo 103-8338 (JP)**

(72) Inventors:
• **NAKAMURA, Chie**
  **Tokyo 103-8338 (JP)**
• **TANAKA, Tomoaki**
  **Tokyo 103-8338 (JP)**
• **TOKUI, Sota**
  **Tokyo 103-8338 (JP)**
• **HASUMI, Mizuki**
  **Tokyo 103-8338 (JP)**

(74) Representative: **Zacco Sweden AB
P.O. Box 5581
Löjtnantsgatan 21
114 85 Stockholm (SE)**

(54) **ADHESIVE TAPE AND PROCESSING METHOD**

(57)     Provided is an adhesive tape having a base material layer and an adhesive layer disposed on the base material layer, wherein the adhesive layer contains a radical photoinitiator and polymer A having polymerizable carbon double bonds, a tensile modulus of elasticity of the adhesive layer after ultraviolet irradiation is 400 MPa or less, and an elongation at break of the adhesive layer after ultraviolet irradiation is 16% or more.

EP 4 242 280 A1

**Description**

Technical Field

The present invention relates to an adhesive tape and a processing method.

Background Art

When a semiconductor package, a semiconductor wafer (hereinafter, also referred to as an "adherend"), or the like is singulated, a tape for semiconductor wafer processing is attached to the adherend and the adherend is temporarily fixed during dicing. This can prevent chip flying during singulation. After dicing, the tape for semiconductor wafer processing is expanded, and the singulated adherend is picked up (peeled) from the tape for semiconductor wafer processing.

An adhesive tape in which a film base material having permeability to ultraviolet ray is coated with an adhesive layer that causes curing reaction by ultraviolet irradiation is typically used as such a tape for semiconductor wafer processing. This ultraviolet curable tape for processing can reduce the adhesive strength of the adhesive layer as curing reaction is allowed to proceed by the ultraviolet irradiation of the adhesive layer after dicing. Therefore, the singulated adherend can be easily picked up.

At the time of the pick-up, the singulated adherend is pushed up using a push-up pin from the back side, in no contact with the adherend, of the adhesive tape, and then picked up. This operation is required to reduce the glue residue of the adhesive tape on the adherend and to be able to pick up the adherend at a high yield even by a small pin height, from the viewpoint of efficiently producing a high-quality electronic component.

However, if the wettability of the adhesive to the adherend is not good in attaching the adhesive tape to the adherend, glue fails to follow the steps, etc. of the adherend so that air bubbles enter this portion. This causes poor curing of the adhesive due to oxygen inhibition or the like during ultraviolet irradiation. Thus, the adhesive may remain uncured on the adherend. If adhesive strength to the adherend is insufficient, cutting water enters the gap between the adherend and the adhesive tape during dicing and thereby contaminates the adherend and further, the singulated adherend flies.

Accordingly, a possible method for compensating for the wettability of the adhesive to the adherend involves increasing the thickness of the adhesive layer, enhancing adhesive strength by blending a low-molecular-weight component, a tackifier, or the like, or enhancing adhesive strength by decreasing the modulus of elasticity of the adhesive layer. In this case, however, the adhesive is melted by frictional heat resulting from blade rotation during dicing and scraped up so that the adhesive scraps may adhere to the adherend. If the adhesive is cured in a scraped-up state by ultraviolet irradiation, the singulated adherend is fixed to the adhesive tape. As a result, pick-up may be difficult by a small pin height, or if pick-up can be done, failure may occur in the adhesive itself because the adhesive cannot be peeled at its interface with the adherend. Thus, the adhesive may remain on the adherend.

As an approach of improving pick-up properties by solving such glue residue, for example, Patent Literature 1 discloses a method of drastically reducing adhesive strength after ultraviolet irradiation by blending a large amount of a relatively low-molecular-weight ultraviolet curable resin component.

Citation List

Patent Literature

Patent Literature 1: Japanese Patent Laid-Open No. 2008-13692

Summary of Invention

Technical Problem

In this case, however, an adhesive after ultraviolet irradiation become too hard, thereby causing a phenomenon in which glue cannot stand tape deformation at the time of pick-up and cracks in the shape of a pin, probably rather becoming responsible for glue residue.

Many irregularities ascribable to fine lines or a circuit pattern are formed on wafer surface, which serves as an adherend, with recent dentification of circuit design. Hence, the adhesive of an adhesive tape is easily filled into fine gaps between the irregularities on circuit surface, and the adhesive constrained by such gaps is cut during peeling and remains on the circuit surface. This facilitates causing glue residue.

The present invention has been made in light of the problems described above. An object of the present invention is to provide an adhesive tape that is unlikely to produce glue residue on an adherend at the time of pick-up and is capable of being picked up by a small pin height, and a processing method using the same.

Solution to Problem

The present inventors have conducted diligent studies on the adhesive design of an adhesive tape in order to attain the object, and consequently completed the present invention by finding that the object can be attained by adjusting the tensile modulus of elasticity and the elongation at break of an adhesive layer after ultraviolet curing.

Specifically, the adhesive tape according to the present invention is as follows.

[1] An adhesive tape comprising

a base material layer and an adhesive layer disposed on the base material layer, wherein
the adhesive layer comprises a radical photoinitiator and a polymer A having a polymerizable carbon double bond,
a tensile modulus of elasticity of the adhesive layer after ultraviolet irradiation is 400 MPa or less, and
an elongation at break of the adhesive layer after ultraviolet irradiation is 16% or more.

[2] The adhesive tape according to [1], wherein
a volume shrinkage rate of the adhesive layer between before and after ultraviolet curing is 0.50 to 10.0%.

[3] The adhesive tape according to [1] or [2], wherein

180° peel strength of the adhesive layer to a silicon wafer before ultraviolet curing is 2.0 to 20.0 N/20 mm at 23°C, and
180° peel strength of the adhesive layer to a silicon wafer after ultraviolet curing is 0.05 to 1.0 N/20 mm at 23°C.

[4] The adhesive tape according to any one of [1] to [3], wherein
a double bond equivalent of the polymer A is 500 to 2500 g/mol.

[5] The adhesive tape according to any one of [1] to [4], wherein
the polymer A has a hydroxy group.

[6] The adhesive tape according to any one of [1] to [5], wherein
a weight-average molecular weight of the polymer A is $1.0 \times 10^5$ to $2.0 \times 10^6$.

[7] The adhesive tape according to any one of [1] to [6], wherein
a glass transition temperature of the polymer A is - 80 to 23°C.

[8] The adhesive tape according to any one of [1] to [7], wherein

the polymer A in the adhesive layer comprises a (meth)acrylic acid ester copolymer, and
the (meth)acrylic acid ester copolymer has a linear shape, a branched shape, or a cross-linked shape.

[9] The adhesive tape according to any one of [1] to [8], wherein
the adhesive layer further comprises a curing agent.

[10] The adhesive tape according to [9], wherein
the curing agent is an isocyanate compound.

[11] The adhesive tape according to [10], wherein
the isocyanate compound comprises a difunctional or higher polyfunctional isocyanate compound.

[12] The adhesive tape according to any one of [1] to [11]
for processing of a semiconductor wafer, a semiconductor device, or various semiconductor packages.

[13] A processing method comprising:

a lamination step of laminating an adhesive tape according any one of [1] to [12] with an adherend; and
a dicing step of processing the adherend in a laminated state of the adhesive tape and the adherend, wherein
the adherend is a semiconductor wafer, a semiconductor device or various semiconductor packages.

Advantageous Effects of Invention

The present invention can provide an adhesive tape that is unlikely to produce glue residue on an adherend at the time of pick-up and is capable of being picked up by a small pin height, and a processing method using the same.

Description of Embodiments

Hereinafter, the mode for carrying out the present invention (hereinafter, referred to as the "present embodiment") will be described in detail. However, the present invention is not limited thereby, and various changes or modifications can be made without departing from the spirit of the present invention.

[Adhesive tape]

The adhesive tape of the present embodiment comprises a base material layer and an adhesive layer disposed on the base material layer, wherein the adhesive layer comprises a radical photoinitiator and polymer A having polymerizable carbon double bonds, a tensile modulus of elasticity of the adhesive layer after ultraviolet irradiation is 400 MPa or less, and an elongation at break of the adhesive layer after ultraviolet irradiation is 16% or more.

A conventional adhesive layer is constituted by, for example, a base polymer having no ultraviolet curability, and a low-molecular-weight component having ultraviolet curability. Hence, a low-molecular-weight component or a polymer component which remains in an unreacted state may remain on adherend surface after ultraviolet irradiation.

By contrast, in the present embodiment, by use of polymer A having polymerizable carbon double bonds, one polymer A is further polymerized and cross-linked to another polymer A by ultraviolet irradiation. Hence, the problem of contamination of adherend surface by a low-molecular-weight component can be circumvented. Furthermore, if some polymerizable carbon double bonds of the polymer A are unreacted, the contamination of adherend surface can also be circumvented as compared with a low-molecular-weight component. In the case of using a low-molecular-weight component having polymerizable carbon double bonds, the low-molecular-weight component also becomes capable of binding to the polymer A and therefore remains easily in the adhesive. This can prevent the low-molecular-weight component from remaining on adherend surface.

In the present embodiment, the mechanical characteristics, i.e., the tensile modulus of elasticity and the elongation at break, of the adhesive layer comprising the polymer A after ultraviolet irradiation are further defined. By use of the adhesive layer having such mechanical characteristics, a chip can be peeled while the adhesive layer is evenly stretched in four directions of the chip at the time of pick-up. As a result, the chip can be peeled from the adhesive layer by a small force. Thus, the chip can be easily peeled even by a small pin height.

Even in the presence of irregularities ascribable to fine lines or a circuit pattern on chip surface, a cured product of the adhesive can be elongated without being broken by stretch. Therefore, the cured product of the adhesive can escape, integrally with its surrounding one, from constraint by the depressions of the chip, leading to reduction in glue residue.

(Tensile modulus of elasticity)

The tensile modulus of elasticity of the adhesive layer after ultraviolet irradiation is 400 MPa or less, preferably 350 MPa or less, more preferably 300 MPa or less, further preferably 150 MPa or less, still further preferably 100 MPa or less, even more preferably 50 MPa or less. The lower limit value of the tensile modulus of elasticity is not particularly limited and is preferably 1.0 MPa or more and may be 3.0 MPa or more.

When the tensile modulus of elasticity of the adhesive layer after ultraviolet irradiation is 400 MPa or less, pick-up by a smaller pin height is achieved. If the tensile modulus of elasticity of the adhesive layer after ultraviolet irradiation is larger than 400 MPa, the adhesive layer is too hard after curing reaction proceeds by ultraviolet irradiation. Therefore, the peeling of a chip from the adhesive layer does not start even if the pin height is increased at the time of pick-up, probably causing poor pick-up. In this case, if the pin height is increased too much, the pin may stick out of the adhesive layer and damage the adhesive tape, or the adhesive layer may crack, causing glue residue on the chip.

The "tensile modulus of elasticity" described in the present specification is a Young's modulus measured at a pulling speed of 5 mm/min and a distance of 50 mm between chucks in a universal tensile tester under a temperature condition of 23°C using an adhesive cut out into a width of 1 cm, a length of 10 cm, and a thickness of 60 to 110 $\mu$m.

(Elongation at break)

The elongation at break of the adhesive layer after ultraviolet irradiation is 16% or more, preferably 22% or more, more preferably 25% or more, further preferably 35% or more, even more preferably 45% or more, still further preferably 55% or more. The upper limit value of the tensile modulus of elasticity is not particularly limited and is preferably 200% or less and may be 90% or less.

When the elongation at break of the adhesive layer after ultraviolet irradiation is 16% or more, pick-up by a smaller pin height is achieved. If the elongation at break of the adhesive layer after ultraviolet irradiation is smaller than 16%, the adhesive layer is too hard after curing reaction proceeds by ultraviolet irradiation. Therefore, the peeling of a chip from the adhesive layer does not start even if the pin height is increased at the time of pick-up, probably causing poor pick-up. In this case, if the pin height is increased too much, the pin may stick out of the adhesive layer and damage the adhesive tape, or the adhesive layer may crack, causing glue residue on the chip.

The "elongation at break" described in the present specification is an elongation at break measured at a pulling speed of 5 mm/min and a distance of 50 mm between chucks in a universal tensile tester under a temperature condition of 23°C using an adhesive cut out into a width of 1 cm, a length of 10 cm, and a thickness of 60 to 110 $\mu$m.

(Volume shrinkage rate)

The volume shrinkage rate of the adhesive layer after ultraviolet irradiation is preferably 0.50 to 10.0%, more preferably 0.70 to 8.0%, further preferably 0.90 to 5.0%, with the volume before ultraviolet irradiation defined as 100%.

When the volume shrinkage rate of the adhesive layer after ultraviolet irradiation is 0.50% or more, the adhesive layer can be sufficiently cured by ultraviolet irradiation and the contact area between the adhesive tape and an adherend is decreased, thereby decreasing adhesive strength. Thus, the resulting tape tends to be able to be more easily peeled.

When the volume shrinkage rate is 10.0% or less, a cured product of the adhesive layer tends to be able to be prevented from being excessively cured. This tends to prevent a phenomenon in which the adhesive layer cannot stand the deformation of the adhesive tape ascribable to the push-up of a pin at the time of pick-up and cracks in the shape of a pin, and thereby causes glue residue.

The "volume shrinkage rate" described in the present specification is a cure shrinkage rate determined from change in specific gravity by measuring a specific gravity before and after curing by hydrostatic weighing (balance method) in accordance with "Methods of measuring density and specific gravity of solid (JIS Z 8807)". The volume shrinkage rate is calculated as follows.

$$\texttt{Volume shrinkage rater = \{(ds - dl) / dl\} × 100}$$

specific gravity before curing: dl, specific gravity after curing: ds

(180° peel strength)

The 180° peel strength $S_0$ of the adhesive layer to a silicon wafer before ultraviolet irradiation is preferably 2.0 to 20.0 N/20 mm, more preferably 4.0 to 16.0 N/20 mm, further preferably 6.0 to 14.0 N/20 mm, at 23°C.

When the 180° peel strength $S_0$ is 2.0 N/20 mm or more, adhesive strength before ultraviolet irradiation tends to be much better. Hence, the adhesive tape is unlikely to be detached from a ring frame, and chip flying or chip cracks are unlikely to occur in a dicing step.

When the 180° peel strength $S_0$ is 20.0 N/20 mm or less, the adhesive is unlikely to be scraped up by a blade in a dicing step, because of small tackiness. Thus, the scraped-up adhesive tends to be unlikely to adhere to the side, etc. of an adherend. This tends to prevent a phenomenon in which the scraped-up adhesive remains as glue residue on the adherend or is ultraviolet-cured as it is to fix a chip, causing poor pick-up, and the fixed chip cracks.

The 180° peel strength $S_1$ of the adhesive layer to a silicon wafer after ultraviolet irradiation is preferably 0.05 to 1.0 N/20 mm, more preferably 0.08 to 0.8 N/20 mm, further preferably 0.10 to 0.6 N/20 mm, at 23°C.

When the 180° peel strength $S_1$ is 0.05 N/20 mm or more, a chip tends to be prevented from being detached or displaced by expanding at the time of pick-up. Specifically, a chip tends to be prevented from being detached or displaced before being pushed up using a pin. This can maintain a state where singulated chips are equally spaced by expanding. Thus, an apparatus can accurately recognize and pick up the chips. When the 180° peel strength $S_1$ is 1.0 N/20 mm or less, a chip is easily peeled from the adhesive layer. Thus, pick-up properties tend to be more improved.

It is preferred that both the 180° peel strength $S_0$ and the 180° peel strength $S_1$ should be satisfied.

The "180° peel strength to a silicon wafer" described in the present specification can be measured in accordance with a method for measuring adhesive strength in JIS Z 0237 (2009). Specifically, the adhesive layer is pressure-bonded to an adherend (silicon wafer) having a washed surface using a pressure bonding apparatus (roller mass: 2 kg), and adhesive strength upon peeling by 180° relative to the adherend is measured with a universal tensile tester in an environment having a temperature of 23°C and a humidity of 50%.

(Adhesive layer)

The adhesive layer comprises a radical photoinitiator and polymer A having polymerizable carbon double bonds and may optionally comprise a curing agent.

(Polymer A)

The polymer A is a polymer having polymerizable carbon double bonds and is a component that constitutes a main component of the adhesive layer. When the adhesive layer is irradiated with ultraviolet ray, the radical photoinitiator generates a radical. The polymerizable carbon double bonds of one polymer A are polymerized with those of another polymer A. As a result, these polymers A become a state cross-linked to each other after ultraviolet irradiation.

Examples of the polymer A include, but are not particularly limited to, (meth)acrylic acid ester copolymers having polymerizable double bonds. Examples of the shape of the (meth)acrylic acid ester copolymer include, but are not particularly limited to, linear shapes, branched shapes, and cross-linked shapes. The polymer A preferably has a cross-linked shape among them. Use of such polymer A improves the cohesion of the adhesive layer and more improves adhesiveness to an adherend while contamination tends to be more reduced. The polymer A having a cross-linked shape or a branched shape may be derived from the polymer A having a linear shape through the binding of some polymerizable double bonds by aging or the like.

Examples of the(meth)acrylic acid ester monomer constituting the (meth)acrylic acid ester copolymer include, but are not particularly limited to, alkyl (meth)acrylate having a linear or branched alkyl group such as a methyl group, an ethyl group, a n-propyl group, an isopropyl group, a n-butyl group, a t-butyl group, an isobutyl group, an amyl group, an isoamyl group, a hexyl group, a heptyl group, a cyclohexyl group, a 2-ethylhexyl group, an octyl group, an isooctyl group, a nonyl group, an isononyl group, a decyl group, an isodecyl group, an undecyl group, a lauryl group, a tridecyl group, a tetradecyl group, a stearyl group, an octadecyl group, and a dodecyl group. One of these alkyl (meth)acrylates may be used alone, or two or more types thereof may be used in combination.

Examples of the monomer component other than the alkyl (meth)acrylate include, but are not particularly limited to: carboxyl group-containing monomers such as acrylic acid, methacrylic acid, carboxyethyl (meth)acrylate, carboxypentyl (meth)acrylate, itaconic acid, maleic acid, fumaric acid, and crotonic acid; acid anhydride monomers such as maleic anhydride and itaconic anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 1-hydroxydecyl (meth)acrylate, 12-hydroxylauryl (meth)acrylate, and (4-hydroxymethylcyclohexyl)methyl (meth)acrylate; sulfonic acid group-containing monomers such as styrenesulfonic acid, allylsulfonic acid, 2-(meth)acrylamido-2-methylpropanesulfonic acid, (meth)acrylamidopropanesulfonic acid, sulfopropyl (meth)acrylate, and (meth)acryloyloxynaphthalenesulfonic acid; and phosphoric acid group-containing monomers such as 2-hydroxyethylacryloyl phosphate. A copolymer of 2-ethylhexyl (meth)acrylate or methacrylic acid is preferred. One of these additional monomers may be used alone, or two or more types thereof may be used in combination.

Among them, a (meth)acrylic acid ester copolymer comprising alkyl (meth)acrylate and a carboxyl group-containing monomer or a (meth)acrylic acid ester copolymer comprising alkyl (meth)acrylate and a hydroxyl group-containing monomer is preferred.

Examples of the method for introducing the polymerizable double bonds to the (meth)acrylic acid ester copolymer include, but are not particularly limited to, methods of reacting a modifying agent having the polymerizable double bonds with the carboxyl group of a carboxyl group-containing monomer, the anhydrous carboxyl group of an acid anhydride monomer, or the hydroxyl group of a hydroxyl group-containing monomer.

For example, an epoxy compound having the polymerizable double bonds can be reacted as a modifying agent with a (meth)acrylic acid ester copolymer comprising a carboxyl group-containing monomer unit to introduce the polymerizable double bonds to the carboxyl group-containing monomer unit via ester bonds. As another example, an isocyanate compound having the polymerizable double bonds can be reacted as a modifying agent with a (meth)acrylic acid ester copolymer comprising a carboxyl group-containing monomer unit to introduce the polymerizable double bonds to the carboxyl group-containing monomer unit via amide bonds.

The modifying agent is not particularly limited as long as the modifying agent has a functional group reactive with a functional group carried by the (meth)acrylic acid ester copolymer and has the polymerizable double bonds. Examples thereof include epoxy compounds having the polymerizable double bonds, and isocyanate compounds having the polymerizable double bonds.

The double bond equivalent of the polymer A is preferably 500 to 2500 g/mol, more preferably 800 to 2000 g/mol, further preferably 1000 to 1600 g/mol. When the double bond equivalent of the polymer A falls within the range described above, the cross-linking reaction of the polymerizable double bonds of the polymer A sufficiently proceeds by ultraviolet irradiation and the contact area with an adherend is decreased by cure shrinkage, thereby sufficiently reducing adhesive strength. Specifically, pick-up performance is more improved because the resulting tape can be easily peeled. A monomer component that has failed to be polymerized at the time of polymer component synthesis may react with a double bond at the side chain of the polymer component during ultraviolet irradiation, leading to the suppression of glue residue.

When the double bond equivalent of the polymer A is 500 g/mol or more, excessive cross-linking can be suppressed. This tends to prevent a phenomenon in which the adhesive layer cannot stand the deformation of the adhesive tape ascribable to the push-up of a pin at the time of pick-up and cracks in the shape of a pin, and thereby causes glue residue. A polar group such as an unreacted carboxyl group remains easily. Thus, adhesive strength to an adherend before ultraviolet irradiation tends to be more improved.

When the double bond equivalent of the polymer A is 2500 g/mol or less, cross-linking reaction sufficiently proceeds and adhesive strength is reduced. Thus, a chip tends to be able to be easily peeled at the time of pick-up.

The "double bond equivalent" described in the present specification is a double bond equivalent determined by measuring an iodine value in accordance with "Test methods for acid value, saponification value, ester value, iodine value, hydroxyl value and unsaponifiable matter of chemical products" (JIS K 0070). Specifically, an iodine monochloride solution was added to a sample so that iodine monochloride was added to double bonds. An excess of I was titrated with a sodium thiosulfate solution. The double bond equivalent was determined according to the following expression.

$$A = \{(B - C) \times f \times 1.269\} / S$$

A: Iodine value
B: Amount of the sodium thiosulfate solution (mL) used in a blank test
C: Amount of the sodium thiosulfate solution (mL) used in titration
f: Factor of the sodium thiosulfate solution
S: Mass of the sample (g)
1.269: Atomic weight of iodine

The amount of the polymerizable double bonds introduced is preferably 40 to 95% by mol, more preferably 43 to 90% by mol, further preferably 45 to 80% by mol, per 100% by mol of reactive monomer units constituting the polymer A. In this context, the "reactive monomer units" refer to a carboxyl group-containing monomer, an acid anhydride monomer, and a hydroxyl group-containing monomer. When the amount of the polymerizable double bonds introduced is 40% by mol or more, adhesive strength is sufficiently reduced after ultraviolet irradiation. Thus, pick-up properties tend to be more improved. When the amount of the polymerizable double bonds introduced is 95% by mol or less, a functional group capable of reacting with the curing agent mentioned later remains in the polymer A. Thus, the anchor failure between a base material film and the adhesive layer tends to be more unlikely to occur. When the amount of the polymerizable double bonds introduced is 95% by mol or less, a polar group such as an unreacted carboxyl group remains easily. Thus, adhesive strength to an adherend before ultraviolet irradiation tends to be more improved.

The polymer A preferably has a hydroxy group. The hydroxy group may be derived from a carboxyl group-containing monomer or the like, may be a hydroxy group derived from a modifying agent, or may be a hydroxy group resulting from the reaction of a monomer unit such as a carboxyl group-containing monomer with a modifying agent. Examples of the hydroxy group resulting from the reaction of a carboxyl group-containing monomer with a modifying agent include cases of reacting an epoxy compound having the polymerizable double bonds with a carboxyl group-containing monomer.

By use of the polymer A having a hydroxy group, a plurality of polymers can be further cross-linked via the hydroxy group when blended with the curing agent mentioned later. Thus, the cohesion of the adhesive layer tends to be more improved. Also, the anchoring properties between a base material film and the adhesive layer are more improved, and cohesive failure and anchor failure are suppressed. Thus, more stable adhesive characteristics tend to be obtained.

The content of the monomer unit having a hydroxy group among monomer units contained in the polymer A is preferably 5 to 40% by mol, more preferably 10 to 30% by mol, further preferably 10 to 25% by mol, per 100% by mol in total of the monomer units. When the content of the monomer unit having a hydroxy group falls within the range described above, the cohesion of the adhesive layer tends to be more improved.

The weight-average molecular weight of the polymer A is preferably $1.0 \times 10^5$ to $2.0 \times 10^6$, more preferably $2.0 \times 10^5$ to $1.0 \times 10^6$, further preferably $2.5 \times 10^5$ to $8.0 \times 10^5$. When the weight-average molecular weight of the polymer A is $1.0 \times 10^5$ or higher, the amount of a high-molecular-weight component is increased. In addition, a higher molecular weight increases a chance that one polymer A is polymerized with another polymer A through the polymerizable double bonds, and therefore tends to more reduce contamination. When the weight-average molecular weight of the polymer A is $2.0 \times 10^6$ or lower, polymer A has mobility, which increases a chance that one polymer A is polymerized with another polymer A, and therefore tends to more reduce contamination. A smaller molecular weight prevents the adhesive from having too high a modulus of elasticity and therefore tends to more improve adhesive strength in an ordinary state. Since the adhesive has good following properties to an adherend and can follow the steps of the adherend, contamination ascribable to poor UV curing caused by oxygen inhibition can be avoided. A soft adhesive is sufficiently susceptible to cure shrinkage by UV irradiation. Therefore, adhesive strength after curing can be sufficiently reduced.

The "weight-average molecular weight" described in the present specification is a molecular weight determined by measuring a sample of the polymer A dissolved in tetrahydrofuran using a gel permeation chromatograph analysis apparatus. The content of component A1 can be determined by calculating the ratio of its area in a chromatogram at a retention time when the weight-average molecular weight reaches 20000 or lower, from a calibration curve of molecular weights based on standard polystyrene with the area of the polymer A in a chromatogram defined as 100 area%.

The glass transition temperature of the polymer A is preferably -80 to 23°C, more preferably -70 to 10°C, further preferably -60 to 0°C. When the glass transition temperature of the polymer A is -80°C or higher, contamination tends to be more reduced. When the glass transition temperature of the polymer A is 23°C or lower, adhesiveness to an adherend tends to be more improved.

The content of the polymer A is preferably 80 to 99.5% by mass, more preferably 85 to 99.5% by mass, further preferably 90 to 99.5% by mass, based on the total amount of the adhesive layer. When the content of the polymer A falls within the range described above, contamination tends to be more reduced.

(Radical photoinitiator)

Examples of the radical photoinitiator include, but are not particularly limited to, alkylphenone photopolymerization initiators, acylphosphine oxide photopolymerization initiators, thioxanthone photopolymerization initiators, aromatic ketones, aromatic onium salt compounds, organic peroxides, thio compounds (thiophenyl group-containing compounds, etc.), a-aminoalkylphenone compounds, hexaarylbiimidazole compounds, ketoxime ester compounds, borate compounds, azinium compounds, metallocene compounds, active ester compounds, compounds having a carbon halogen bond, and alkylamine compounds.

Among them, an alkylphenone photopolymerization initiator is preferred.

The content of the radical photoinitiator is preferably 0.1 to 5.0% by mass, more preferably 0.2 to 4.0% by mass, further preferably 0.3 to 3.0% by mass, based on the total amount of the adhesive layer. When the content of the radical photoinitiator falls within the range described above, contamination tends to be more reduced.

(Curing agent)

Examples of the curing agent can include, but are not particularly limited to, isocyanate compounds, epoxy compounds, and amine compounds. Among them, an isocyanate compound is preferred. By use of such a curing agent, the cohesion of the adhesive layer tends to be more improved. One of these curing agents may be used alone, or two or more thereof may be used in combination.

Examples of the isocyanate compound include, but are not particularly limited to: aromatic diisocyanate such as tolylene diisocyanate, 4,4-diphenylmethane diisocyanate, and xylylene diisocyanate; alicyclic diisocyanate such as isophorone diisocyanate and methylenebis(4-cyclohexyl isocyanate); and aliphatic diisocyanate such as hexamethylene diisocyanate and trimethylhexamethylene diisocyanate. One of these isocyanate compounds may be used alone, or two or more thereof may be used in combination.

Among them, the curing agent is preferably a difunctional or higher polyfunctional isocyanate compound. By use of such a curing agent, a plurality of polymers A can be cross-linked by the curing agent. Therefore, the cohesion of the adhesive layer tends to be more improved. Also, the anchoring properties between a base material film and the adhesive layer are improved. Thus, more stable adhesive characteristics tend to be obtained.

The content of the curing agent is preferably 0.10 to 5.0 parts by weight, more preferably 0.15 to 3.0 parts by weight, further preferably 0.20 to 2.0 parts by weight, with respect to 100 parts by weight of the polymer A. When the content of the curing agent is 0.1 parts by weight or more, the cross-link density of the adhesive layer is more improved and cohesive failure resulting from peeling is more suppressed. Thus, contamination caused by cohesive failure tends to be more reduced. When the content of the curing agent is 5.0 parts by weight or less, the cross-link density is more reduced and the modulus of elasticity is decreased. Therefore, adhesive strength tends to be more improved.

The content of the curing agent is preferably 0.10 to 2.0% by mass, more preferably 0.15 to 1.5% by mass, further preferably 0.20 to 1.0% by mass, based on the total amount of the adhesive layer. When the content of the curing agent falls within the range described above, contamination tends to be more reduced.

(Other additives)

The adhesive layer of the present embodiment can be supplemented, if necessary, with a tackifier, a cross-linking retarder, an antioxidant, and the like.

Examples of the tackifier include, but are not particularly limited to, petroleum resin, terpene resin, terpene phenol resin, aromatic modified terpene resin, chromane-indene resin, natural resin rosin, modified rosin, glycerin ester rosin, pentaerythritol ester rosin, phenol resin, xylene resin, alicyclic petroleum resin, styrene resin, and dicyclopentadiene resin.

The cross-linking retarder is not particularly limited and is, for example, a compound that can suppress excessive elevation in viscosity of an adhesive composition containing an isocyanate curing agent by blocking an isocyanate group carried by the curing agent in the adhesive composition. Examples of such a cross-linking retarder include, but are not particularly limited to: β-diketones such as acetylacetone, hexane-2,4-dione, heptane-2,4-dione, and octane-2,4-dione; β-ketoesters such as methyl acetoacetate, ethyl acetoacetate, propyl acetoacetate, butyl acetoacetate, octyl acetoacetate, oleyl acetoacetate, lauryl acetoacetate, and stearyl acetoacetate; and benzoyl acetone.

Examples of the antioxidant include, but are not particularly limited to, methylhydroquinone, hydroquinone, 2,2-methylene-bis(4-methyl-6-tertiary butylphenol), catechol, hydroquinone monomethyl ether, mono-tertiary butylhydroquinone, 2,5-di-tertiary butylhydroquinone, p-benzoquinone, 2,5-diphenyl-p-benzoquinone, 2,5-di-tertiary butyl-p-benzoquinone, picric acid, citric acid, phenothiazine, tertiary butyl catechol, 2-butyl-4-hydroxyanisol, 2,6-di-tertiary butyl-p-cresol, and 4-[[4,6-bis(octylthio)-1,3,5-triazin-2-yl]amino]-2,6-di-tertiary butylphenol.

(Thickness)

The thickness of the adhesive layer is usually 1.0 to 250 μm, preferably 2.0 to 50 μm, further preferably 5.0 to 40 μm. When the thickness of the adhesive layer is 1.0 μm or larger, sufficient adhesive strength can be secured. Therefore, semiconductor chips divided by expanding are easily prevented from flying. When the thickness of the adhesive layer is 250 μm or smaller, cost tends to be more reduced.

For use as an adhesive tape for semiconductor wafer processing, the thicknesses of the base material layer and the adhesive layer are preferably adjusted within the ranges described above such that the total thickness of the tape is preferably in the range of 60 to 250 μm. The total thickness of the tape for semiconductor wafer processing is more preferably 70 to 200 μm, further preferably 70 to 180 μm.

(Base material layer)

Examples of the material constituting the base material layer include, but are not particularly limited to, polyvinyl chloride, polyethylene terephthalate, ethylene-vinyl acetate copolymers, ethylene-acrylic acid-acrylic acid ester films, ethylene-ethyl acrylate copolymers, polyethylene, polypropylene, propylene copolymers, ethylene-acrylic acid copolymers, and ionomer resin in which ethylene-(meth)acrylic acid copolymers, ethylene-(meth)acrylic acid-(meth)acrylic acid ester copolymers, or the like are cross-linked through metal ions. The base material film constituting the base material layer may be such a resin used singly, a mixture or a copolymer of two or more of these resins, or a laminate thereof.

The thickness of the base material layer can be appropriately selected without impairing workability. The thickness of the base material layer is usually 10 to 500 μm, preferably 50 to 200 μm, further preferably 70 to 150 μm. When the thickness of the base material layer is adjusted to within the range described above, the resulting base material layer is free from practical problems and economically effective. When the base material layer is constituted by a plurality of base material films, the thickness of the whole base material layer is preferably adjusted so as to fall within the range described above.

The base material layer may be surface-treated chemically or physically, if necessary, in order to improve its tight contact with the adhesive layer. Examples of the surface treatment include corona treatment, chromic acid treatment, ozone exposure, flame exposure, high-voltage electric shock exposure, and ionization radiation treatment.

(Protective film)

The adhesive tape of the present embodiment may have a protective film laminated onto the adhesive layer in order to protect the adhesive layer. The protective film is peeled when the adhesive tape is used. Therefore, an excellently peelable film is preferred. Examples of the protective film include, but are not particularly limited to, films that are made of fluorine resin and have low surface energy, and films of polyethylene terephthalate having a surface treated with a silicone release agent.

(Purpose)

The adhesive tape of the present embodiment can be suitably used for the purpose of processing a semiconductor wafer, a semiconductor device, or various semiconductor packages. The semiconductor wafer may be an unsingulated semiconductor wafer with an electronic circuit or the like formed thereon. The semiconductor device refers to various singulated semiconductor chips or an element comprising these chips. The semiconductor package refers to an article having a semiconductor chip, a resin for protection thereof, and a connection terminal which connects the semiconductor chip to the outside.

[Method for producing adhesive tape]

Examples of the method for producing the adhesive tape include, but are not particularly limited to, methods of forming an adhesive layer on a base material layer.

The base material layer of the adhesive tape of the present embodiment can be produced in accordance with a well-known technique. The approach of forming the base material layer is not particularly limited. The various materials described above are mixed by routine melt kneading or the like or using various mixing apparatuses (single-screw or twin-screw extruders, rolls, Banbury mixers, various kneaders, etc.) such that the respective components are uniformly dispersed. The mixture is molded into a base material by a T-die method, a calendar method, or an inflation method. A method of forming a film by a T-die method using an extruder having good thickness precision is preferred.

The adhesive layer of the adhesive tape of the present embodiment can be produced in accordance with a well-known technique. The approach of forming the adhesive layer is not particularly limited. The various materials described above are dissolved in a solvent such as an organic solvent to prepare a varnish, with which a protective film is then coated by a knife coating method, a roll coating method, a spray coating method, a gravure coating method, a bar coating method, or a curtain coating method, etc. The solvent is removed to form an adhesive layer. This layer is laminated onto the base material layer to prepare an adhesive tape.

In the present embodiment, the adhesive layer thus formed may be subjected to aging treatment. In the aging treatment, the formed adhesive layer is stored at a predetermined temperature. The temperature condition is not particularly limited and is preferably 30 to 50°C, more preferably 35 to 45°C. The storage time is not particularly limited and is preferably 24 to 150 hours, more preferably 48 to 100 hours. This aging treatment performed changes the adhesive strength or curing characteristics of the adhesive layer.

[Processing method]

The processing method of the present embodiment is a method comprising: a lamination step of laminating the adhesive tape described above with an adherend; and a dicing step of processing the adherend in a laminated state of the adhesive tape and the adherend, wherein a semiconductor wafer, a semiconductor device or various semiconductor packages are processed as the adherend. The processing method of the present embodiment may optionally have an ultraviolet irradiation step of irradiating the adhesive tape with ultraviolet ray after the dicing step, or a pick-up step of picking up singulated chips from the adhesive tape after ultraviolet irradiation.

The singulation method in the dicing step is not particularly limited, and a conventional method known in the art can be used. For example, a silicon wafer can be cut into semiconductor chips by the high-speed rotation of a dicing blade containing diamond abrasive grains using a dicing apparatus.

The ultraviolet irradiation method is not particularly limited, and a conventional method known in the art can be used. For example, the adhesive tape in the dicing step is irradiated with ultraviolet ray using an ultraviolet irradiation apparatus.

Then, the pick-up method is not particularly limited, and a conventional method known in the art can be used. For example, the adhesive tape after ultraviolet irradiation is drawn along the direction of the surface using an expanding apparatus, and the chips can be picked up in a separated state of the chips using a pick-up apparatus.

Examples

Hereinafter, the present invention will be described more specifically with reference to Examples and Comparative Examples. However, the present invention is not limited by these examples.

(Example 1)

92 parts by weight of 2-ethylhexyl acrylate, 8 parts by weight of acrylic acid, and 0.05 parts by weight of an initiator (azobisisobutyronitrile) were copolymerized at 65°C for 24 hours in ethyl acetate to obtain a solution containing an acrylic polymer.

Glycidyl methacrylate was reacted with the carboxyl group of the acrylic acid unit in the acrylic polymer to obtain a side-chain double bond introduction type acrylic polymer having double bonds introduced to side chains. In this operation, both the materials were reacted such that the amount of glycidyl methacrylate introduced was 80 mol (80% by mol) per 100 mol of the methacrylic acid unit in the acrylic polymer.

Subsequently, 0.5 parts by weight of a trimethylolpropane-modified tolylene diisocyanate curing agent (Nippon Polyurethane Industry Co., Ltd.; CORONATE L-45E) as a polyisocyanate compound, and 2.1 parts by weight of 2,2-dimethoxy-2-phenylacetophenone (manufactured by BASF SE; Omnirad 651) as a radical photoinitiator were added to the solution containing 100 parts by weight of the side-chain double bond introduction type acrylic polymer to prepare a resin composition serving as an ultraviolet curable adhesive.

A release-treated surface of a polyethylene terephthalate protective film subjected to release treatment in advance was coated with this resin composition such that the thickness of an adhesive layer after drying was 20 μm. The resultant was dried at 100°C for 1 minute and then laminated onto a corona-treated surface of an ionomer film (base material resin film) of an ethylene-methacrylic acid-acrylic acid ester copolymer whose surface to be laminated with the adhesive layer was subjected to corona treatment in advance. The adhesive was thereby transferred to the base material resin film. The resultant was aged in an atmosphere of 40°C for 72 hours to obtain an adhesive tape.

(Example 2)

An adhesive tape was prepared in the same manner as in Example 1 except that the amount of glycidyl methacrylate introduced was 60 mol (60% by mol) per 100 mol of the acrylic acid unit in the acrylic polymer.

(Example 3)

An adhesive tape was prepared in the same manner as in Example 1 except that the amount of the curing agent used was 0.3 parts by weight.

(Example 4)

An adhesive tape was prepared in the same manner as in Example 1 except that 97 parts by weight of 2-ethylhexyl acrylate, 3 parts by weight of acrylic acid, and 0.05 parts by weight of an initiator (azobisisobutyronitrile) were copolymerized at 65°C for 24 hours in ethyl acetate to obtain a solution containing an acrylic polymer.

(Example 5)

An adhesive tape was prepared in the same manner as in Example 1 except that: the amount of glycidyl methacrylate introduced was 70 mol (70% by mol) per 100 mol of the acrylic acid unit in the acrylic polymer; and the amount of the curing agent used was 0.2 parts by weight.

(Comparative Example 1)

An adhesive tape was prepared in the same manner as in Example 1 except that the weight-average molecular weight of the acrylic polymer was adjusted by adjusting the amount of the initiator.

(Comparative Example 2)

An adhesive tape was prepared in the same manner as in Example 1 except that: glycidyl methacrylate was not reacted with the acrylic polymer prepared in Example 1, and instead, ultraviolet polymerizable urethane acrylate was separately added thereto; and in addition, the amounts of the curing agent and the initiator were adjusted.

Each sample prepared as described above was subjected to evaluation tests on a tensile modulus of elasticity, an elongation at break, a volume shrinkage rate, and 180° peel strength as described below. The obtained results are summarized in Table 1 below.

<Tensile modulus of elasticity and elongation at break>

The adhesive tape was irradiated with ultraviolet ray at 150 mJ/cm$^2$ from a high-pressure mercury lamp. Then, the adhesive layer was cut into a width of 1 cm, a length of 10 cm, and a thickness of 60 to 110 μm and used as a sample. The tensile modulus of elasticity and the elongation at break of the adhesive layer after ultraviolet irradiation were measured with a universal tensile tester (manufactured by Orientec Co., Ltd., Tensilon, model: RTG-1210) in an environment having a temperature of 23°C and a humidity of 50%.

    Measurement mode: Pulling
    Pulling speed: 5 mm/min
    Distance between chucks: 50 mm

<Volume shrinkage rate>

The volume shrinkage rate was a cure shrinkage rate determined from change in specific gravity by measuring a specific gravity before and after curing by hydrostatic weighing (balance method) in accordance with Methods of measuring density and specific gravity of solid in JIS Z 8807. The volume shrinkage rate is determined according to the following expression.

$$\text{Volume shrinkage rate } r = \{(ds - dl) / dl\} \times 100$$

specific gravity before curing: dl, specific gravity after curing: ds

<Weight-average molecular weight>

10 mg of the side-chain double bond introduction type acrylic polymer synthesized as described above was dissolved in 10 mL of tetrahydrofuran (THF, stabilizer-free, manufactured by Wako Pure Chemical Industries, Ltd.), and the solution was filtered through a membrane filter (made of PTFE, 0.50 $\mu$m) and subjected to analysis. Measurement conditions for the weight-average molecular weight are given below.

(Analysis apparatus)

Gel permeation chromatograph analysis apparatus (DGU-20AC, etc., manufactured by Shimadzu Corp.)

(Measurement conditions)

Standard: Shodex STANDARD (Type: SM-105, manufactured by Showa Denko K.K.)

Amount of sample introduced: 20 $\mu$L

Mobile phase: THF
Flow rate: 1 mL/min
Column: Shim-pack GPC-80M (300 mm $\times$ 8.0 mm I.D.)
Column temperature: 40°C
Detector: Differential refractive index detector (RID)

<Glass transition temperature>

The glass transition temperature of the polymer A was measured by differential scanning calorimetry (DSC) based on JIS K 7121.

<180° peel strength>

The adhesive strength of the adhesive tape was measured in accordance with a method for measuring adhesive strength (method 1: testing method of peeling tapes and sheets by 180° with respect to stainless test plates) in JIS Z 0237 (2009) . Specifically, the adhesive layer was pressure-bonded to a silicon wafer having a washed surface using a pressure bonding apparatus (roller mass: 2 kg), and 180° peel strength $S_0$ upon peeling of the adhesive tape by 180° relative to the silicon wafer was measured with a universal tensile tester (manufactured by Orientec Co., Ltd., Tensilon, model: RTG-1210) in an environment having a temperature of 23°C and a humidity of 50%.
Also, the adhesive tape was pressure-bonded to a silicon wafer having a washed surface using a pressure bonding apparatus (roller mass: 2 kg), and the adhesive tape was irradiated with ultraviolet ray at 150 mJ/cm$^2$ from a high-pressure mercury lamp. Then, 180° peel strength $S_1$ upon peeling of the adhesive tape by 180° relative to the silicon wafer was measured in the same manner as above. Measurement conditions are given below.

(Measurement conditions)

Measurement mode: Pulling
Pulling speed: 300 mm/min
Distance between chucks: 50 mm
Measurement sample width: 20 mm

<Double bond equivalent>
The double bond equivalent was a double bond equivalent determined by measuring an iodine value in accordance with "Test methods for acid value, saponification value, ester value, iodine value, hydroxyl value and unsaponifiable matter of chemical products" (JIS K 0070)". Specifically, an iodine monochloride solution was added to a sample so that iodine monochloride was added to double bonds. An excess of I was titrated with a sodium thiosulfate solution. The double bond equivalent was determined according to the following expression.

$$A = \{(B - C) \times f \times 1.269\} / S$$

A: Iodine value
B: Amount of the sodium thiosulfate solution (mL) used in a blank test
C: Amount of the sodium thiosulfate solution (mL) used in titration
f: Factor of the sodium thiosulfate solution
S: Mass of the sample (g)
1.269: Atomic weight of iodine

<Dicing step>

The adhesive tape prepared as described above was laminated to the back side of 100 mm in width $\times$ 50 mm in depth $\times$ 0.76 mm in thickness epoxy encapsulation resin using a tape mounter apparatus equipped with a roller. Subsequently, the epoxy encapsulation resin was diced into 3.2 mm $\times$ 3.2 mm semiconductor chips using a dicing blade. Main setting conditions for dicing are as given below.

(Setting conditions)

Dicing apparatus: DAD341 manufactured by DISCO Corp.
Dicing blade: P1A861 SDC240N75BR597 manufactured by DISCO Corp.
Dicing blade rotation speed: 25,000 rpm
Dicing blade feed rate: 35 mm/sec
Cutting water temperature: 25°C
Amount of cutting water: 1.0 L/min

<Pick-up step>

After the dicing step, the adhesive layer was cured by ultraviolet irradiation at 150 mJ/cm$^2$. Then, the semiconductor chips were picked up and peeled from the adhesive tape. Main setting of pick-up is as given below. A needle pin push-up height (pin height) was first set to 0.1 mm, and the pick-up of 10 semiconductor chips was attempted. When all the semiconductor chips were not able to be picked up, the needle pin push-up height was increased by 0.1 mm and the pick-up of 10 semiconductor chips was attempted. This operation was repeated.

(Setting conditions)

Pick-up apparatus: CAP-300 II manufactured by Canon Machinery Inc.
Needle pin shape: 250 $\mu$m R
Needle pin push-up height: 0.1 to 1.0 mm
Expanding level: 8 mm
Push-up rate: 10,000 $\mu$m/sec

Evaluation in Table 1 will be described.

<Glue residue property>

After dicing and pick-up steps, the presence or absence of glue residue on the adherend was observed under a microscope.

◎ (excellent): No glue adhered onto the chip, and contamination was also absent thereon.
O (good): No glue adhered onto the chip, but light contamination was present thereon.
△ (fair): No glue adhered onto the chip, but dark contamination was present thereon.
× (poor): Glue adhered onto the chip, and contamination was seen thereon.

In this context, the "light contamination" refers to the extent that color at a location, to which the tape had been affixed, of the silicon wafer was slightly changed. The "dark contamination" refers to an evidently found tape trace.

<Pick-up yield>

A pick-up test was conducted as to pin heights from 0.1 mm to 1.0 mm by 0.1 mm at the time of pick-up. More specifically, the pick-up of 100 chips was attempted at each pin height, and the percentage of chips that were able to be picked up (pick-up yield) was confirmed on a pin height basis. Then, the minimum value of the pin height at which the pick-up yield of chips reached 95% or more is described in the table. If the pick-up yield of chips failed to reach 95% or more even at the pin height of 1.0 mm, "-" was described in the table.

[Table 1]

| | | | Example | | | | | Comparative Example | |
|---|---|---|---|---|---|---|---|---|---|
| | | | 1 | 2 | 3 | 4 | 5 | 1 | 2 |
| Polymer A | Starting material | 2-Ethylhexyl acrylate [parts by weight] | 92 | 92 | 92 | 97 | 92 | 92 | 40 |
| | | Methyl acrylate [parts by weight] | - | - | - | - | - | - | 45 |
| | | Acrylic acid [parts by weight] | 8 | 8 | 8 | 3 | 8 | 8 | 5 |
| | | 2-Hydroxyethyl acrylate [parts by weight] | - | - | - | - | - | - | 10 |
| | | Modifying agent: glycidyl methacrylate [amount reacted: mol%] | 80 | 60 | 80 | 80 | 70 | 80 | - |
| | Physical property | Double bond equivalent [g/mol] | 1200 | 1600 | 1200 | 900 | 1400 | 1200 | - |
| | | Ratio of unit having OH group [% by mol] | 14 | 11 | 14 | 5 | 13 | 14 | 10 |
| | | Glass transition temperature [°C] | -42 | -42 | -42 | -46 | -42 | -42 | -26 |
| | | Weight-average molecular weight (Mw) | $3.0 \times 10^5$ | $3.0 \times 10^5$ | $3.0 \times 10^5$ | $3.0 \times 10^5$ | $3.0 \times 10^5$ | $8.0 \times 10^5$ | $2.0 \times 10^5$ |

(continued)

| Resin composition | | | Example | | | | | Comparative Example | |
|---|---|---|---|---|---|---|---|---|---|
| | | | 1 | 2 | 3 | 4 | 5 | 1 | 2 |
| | Starting material | Polymer A [parts by weight] | 100 | 100 | 100 | 100 | 100 | 100 | 100 |
| | | Radical photoinitiator [parts by weight] | 2.10 | 2.10 | 2.10 | 2.10 | 2.10 | 2.10 | 7.00 |
| | | Curing agent [parts by weight] | 0.50 | 0.50 | 0.30 | 0.50 | 0.20 | 0.50 | 1500 |
| | | Ultraviolet curable urethane acrylate [parts by weight] | - | - | - | - | - | - | 90 |
| | Physical property | Tensile modulus of elasticity after ultraviolet irradiation [MPa] | 100 | 9.0 | 5.0 | 16.0 | 2.0 | 180.0 | 470.0 |
| | | Elongation at break after ultraviolet irradiation [%] | 40.0 | 45.0 | 65.0 | 30.0 | 150.0 | 150 | 5.0 |
| | | Volume shrinkage rate [%] | 2.0 | 1.0 | 2.0 | 2.3 | 1.5 | 0.3 | 4.3 |
| | | 180° peel strength $S_0$ before ultraviolet irradiation [N/20mm] | 8.0 | 12.0 | 8.5 | >3.0 | 13.6 | 4.0 | 12.0 |
| | | 180° peel strength $S_1$ after ultraviolet irradiation [N/20mm] | 0.18 | 0.35 | 0.15 | 0.38 | 0.21 | 0.80 | 0.13 |
| | Evaluation | Glue residue property | ◎ | ○ | ○ | ○ | ○ | △ | × |
| | | Pin height at pick-up yield of 95% or more [mm] | 0.3 | 0.6 | 0.4 | 0.6 | 0.7 | - | 0.7 |

Industrial Applicability

The adhesive tape of the present invention has industrial applicability as a tape for semiconductor wafer processing, particularly, as an adhesive tape for use in a dicing step.

## Claims

1. An adhesive tape comprising

   a base material layer and an adhesive layer disposed on the base material layer, wherein
   the adhesive layer comprises a radical photoinitiator and a polymer A having a polymerizable carbon double bond,
   a tensile modulus of elasticity of the adhesive layer after ultraviolet irradiation is 400 MPa or less, and
   an elongation at break of the adhesive layer after ultraviolet irradiation is 16% or more.

2. The adhesive tape according to claim 1, wherein
   a volume shrinkage rate of the adhesive layer between before and after ultraviolet curing is 0.50 to 10.0%.

3. The adhesive tape according to claim 1 or 2, wherein

   180° peel strength of the adhesive layer to a silicon wafer before ultraviolet curing is 2.0 to 20.0 N/20 mm at 23°C, and
   180° peel strength of the adhesive layer to a silicon wafer after ultraviolet curing is 0.05 to 1.0 N/20 mm at 23°C.

4. The adhesive tape according to any one of claims 1 to 3, wherein
   a double bond equivalent of the polymer A is 500 to 2500 g/mol.

5. The adhesive tape according to any one of claims 1 to 4, wherein
   the polymer A has a hydroxy group.

6. The adhesive tape according to any one of claims 1 to 5, wherein
   a weight-average molecular weight of the polymer A is $1.0 \times 10^5$ to $2.0 \times 10^6$.

7. The adhesive tape according to any one of claims 1 to 6, wherein
   a glass transition temperature of the polymer A is - 80 to 23°C.

8. The adhesive tape according to any one of claims 1 to 7, wherein

   the polymer A in the adhesive layer comprises a (meth)acrylic acid ester copolymer, and
   the (meth)acrylic acid ester copolymer has a linear shape, a branched shape, or a cross-linked shape.

9. The adhesive tape according to any one of claims 1 to 8, wherein
   the adhesive layer further comprises a curing agent.

10. The adhesive tape according to claim 9, wherein
    the curing agent is an isocyanate compound.

11. The adhesive tape according to claim 10, wherein
    the isocyanate compound comprises a difunctional or higher polyfunctional isocyanate compound.

12. The adhesive tape according to any one of claims 1 to 11
    for processing of a semiconductor wafer, a semiconductor device, or various semiconductor packages.

13. A processing method comprising:

    a lamination step of laminating an adhesive tape according any one of claims 1 to 12 with an adherend; and
    a dicing step of processing the adherend in a laminated state of the adhesive tape and the adherend, wherein
    the adherend is a semiconductor wafer, a semiconductor device or various semiconductor packages.

# INTERNATIONAL SEARCH REPORT

| International application No. |
| --- |
| **PCT/JP2021/038724** |

## A. CLASSIFICATION OF SUBJECT MATTER

*C09J 133/04*(2006.01)i; *C09J 175/04*(2006.01)i; *C09J 201/02*(2006.01)i; *H01L 21/301*(2006.01)i; *C09J 7/38*(2018.01)i
FI: C09J7/38; C09J201/02; C09J133/04; C09J175/04; H01L21/78 M

According to International Patent Classification (IPC) or to both national classification and IPC

## B. FIELDS SEARCHED

Minimum documentation searched (classification system followed by classification symbols)

C09J133/04; C09J175/04; C09J201/02; H01L21/301; C09J7/38

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
| --- | --- | --- |
| X | JP 2009-197248 A (NITTO DENKO CORP.) 03 September 2009 (2009-09-03) claim 1, paragraphs [0006]-[0012], [0017]-[0029], [0035], examples | 1-13 |
| Y | | 1-13 |
| Y | JP 2010-177699 A (NITTO DENKO CORP.) 12 August 2010 (2010-08-12) claim 7, paragraph [0021] | 1-13 |
| Y | WO 2009/110426 A1 (LINTEC CORP.) 11 September 2009 (2009-09-11) claim 4, paragraphs [0049]-[0052] | 1-13 |

☐ Further documents are listed in the continuation of Box C.　　☑ See patent family annex.

\* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
| --- | --- |
| **15 December 2021** | **11 January 2022** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

**INTERNATIONAL SEARCH REPORT**
**Information on patent family members**

International application No.

**PCT/JP2021/038724**

| Patent document cited in search report | | | Publication date (day/month/year) | Patent family member(s) | Publication date (day/month/year) |
|---|---|---|---|---|---|
| JP | 2009-197248 | A | 03 September 2009 | (Family: none) | |
| JP | 2010-177699 | A | 12 August 2010 | (Family: none) | |
| WO | 2009/110426 | A1 | 11 September 2009 | US 2011/0045290 A1 claim 4, paragraphs [0059]-[0062] KR 10-2010-0138903 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2008013692 A